# EUROPEAN PATENT APPLICATION

(11) **EP 2 953 434 A1**
(43) Date of publication of application: **09.12.2015**
(21) Application number: 14171289.3
(22) Date of filing: 05.06.2014
(51) Int. Cl.: H05K 1/14, H05K 3/36

(54) **Electronic circuit board assembly**

(71) Applicant: Home Control Singapore Pte. Ltd., Singapore 319762 (SG)
(72) Inventor: The designation of the inventor has not yet been filed
(74) Representative: Ferreccio, Rinaldo

(57) **Abstract**

An electronic circuit board assembly (17) comprises a first circuit board (16, 30), a second circuit board (15, 28), and a connecting circuit board (10,22) electrically connecting the first circuit board with the second circuit board. A first connecting structure electrically connects the first circuit board to the connecting circuit board, at least one of the first circuit board and connecting circuit board comprising a first slit, part of the other one of the first circuit board and connecting circuit board being slotted through the first slit. A second connecting structure electrically connects the second circuit board to the connecting circuit board, at least one of the second circuit board and connecting circuit board comprising a second slit, part of the other one of the second circuit board and connecting circuit board being slotted through the second slit.

## Description

### FIELD OF THE INVENTION

The invention relates to an electronic circuit board assembly comprising a first circuit board and a second circuit board.

The invention further relates to an electronic circuit board, a method for manufacturing an electronic circuit board assembly, and a kit for manufacturing an electronic circuit board assembly.

### BACKGROUND OF THE INVENTION

A data processing terminal is disclosed in US 2005/0017918A1 with title "Data processing terminal, parent substrate, child substrate, terminal design apparatus and method, computer program, and information storage medium", which is incorporated herein by reference.

The data processing terminal comprises a hollow housing which contains a parent board, a child board, and a connector for connecting both boards. The parent board is mounted with a variety of data processing circuits comprised of integrated circuits, while child board is mounted with a memory circuit such as RAM (Random Access Memory).

The child board can be connected to the parent board through the connectors and is removable in the vertical direction. When connected, the child board is arranged parallel to the parent board.

The connector, which connects the two boards, has a plurality of terminals arranged in parallel. With such a structure, as the child board is mounted on the parent board, the data processing circuit on the parent board is connected to the memory circuit on the child board through the signal terminals of connector.

The data processing terminal may be used in a PDA (Personal Digital Assistant) to and may communicate data processed thereby to the outside using a wireless communication function.

### SUMMARY OF THE INVENTION

It is an object of the invention to provide an improved circuit board assembly. The invention is defined by the independent claims. The dependent claims define advantageous embodiments.

On aspect of the invention provides an electronic circuit board assembly, which comprises a first circuit board, a second circuit board, and a connecting circuit board. The connecting circuit board electrically connects the first circuit board with the second circuit board, preferably through direct soldered connections.

The electronic circuit board assembly has a first connecting structure electrically connecting the first circuit board to the connecting circuit board, at least one of the first circuit board and connecting circuit board comprising a first slit, part of the other one of the first circuit board and connecting circuit board being slotted through the first slit.

The electronic circuit board assembly also has a second connecting structure electrically connecting the second circuit board to the connecting circuit board, at least one of the second circuit board and connecting circuit board comprising a second slit, part of the other one of the second circuit board and connecting circuit board being slotted through the second slit. The first slit is different from the second slit.

Using a circuit board to connect a first and second circuit board together avoids the use of more expensive connecting method, e.g. connectors, or side-soldering. Designers can use additional circuits board, e.g. to overcome size limitations or form-factor limitations without unduly increasing the costs of the design. Moreover, it allows the use of less expensive materials for the circuit boards, e.g. single sided instead of double sided PCBs.

The location of the first and second slit may vary. For each slit, there is a choice: either the connecting board may be inserted into the slit or the connecting board may comprise the slit.

In an embodiment, the connecting board is a double-sided PCB. The connecting board comprises on each side: a first row of solder pads, a second row of solder pads, and traces connecting the first row of solder pads with the second row of solder pads. The first circuit board comprises two rows of solder pads, the two rows of solder pads of the first circuit board being soldered to a first row of solder pads on each side of the connecting circuit board, the second circuit board comprises two rows of solder pads, the two rows of solder pads of the second circuit board being soldered to the second row of solder pads on each side of the connecting circuit board.

Using a double-sided PCB for the connecting board doubles the number of possible connections between the first and second board. The costs increase associated with using a double instead of a single-sided PCB is small, because the connecting board is small.

In an embodiment, the first and/or second circuit boards are single sided printed circuit boards.

An aspect of the invention concerns an electronic circuit board for use in an electronic circuit board assembly. An aspect of the invention concerns a method for manufacturing an electronic circuit board assembly. An aspect of the invention concerns a kit for manufacturing an electronic circuit board assembly

The electronic circuit board assembly may be comprised in electronic devices, e.g. household appliances, computing devices, remote controls and the like.

These and other aspects of the invention are apparent from and will be elucidated with reference to the embodiments described hereinafter.

### BRIEF DESCRIPTION OF THE DRAWINGS

Fig. 1 is a schematic front view of an embodiment of a connecting circuit board,
Fig. 2a is a schematic top view of an embodiment of a second circuit board,
Fig. 2b is a schematic bottom view of the embodiment of the second circuit board,
Fig. 3a is a schematic top view of an embodiment of first circuit board,
Fig. 3b is a schematic bottom view of the embodiment of the first circuit board,
Fig. 4a is a schematic projective view of an embodiment of an electronic circuit board assembly,
Fig. 4b is a schematic side view of an embodiment of an electronic circuit board assembly,
Fig. 4c is a schematic top view of an embodiment of an electronic circuit board assembly,
Fig. 4d is a schematic bottom view of an embodiment of an electronic circuit board assembly,
Fig. 5a is a schematic front view of an embodiment of a connecting circuit board having two parts arranged to slot through a slit.
Fig. 5b is a schematic top view of an embodiment of a second circuit board having a second slit and a further second slit.
Fig. 6a is a schematic back view of an embodiment of a connecting circuit board,
Fig. 6b is a schematic front view of an embodiment of a connecting circuit board,
Fig. 6c is a schematic top view of an embodiment of a second circuit board,
Fig. 6d is a schematic bottom view of the embodiment of the second circuit board,
Fig. 6e is a schematic top view of an embodiment of a first circuit board,
Fig. 6f is a schematic bottom view of the embodiment of the first circuit board,
Fig. 7a is a schematic back view of an embodiment of a connecting circuit board,
Fig. 7b is a schematic front view of an embodiment of a connecting circuit board,
Fig. 7c is a schematic top view of an embodiment of a second circuit board,
Fig. 7d is a schematic bottom view of the embodiment of the second circuit board,
Fig. 7e is a schematic top view of an embodiment of a first circuit board,
Fig. 7f is a schematic bottom view of the embodiment of the first circuit board,
Fig. 8 is a schematic flowchart of a method of manufacturing an electronic circuit board assembly.

Items which have the same reference numbers also have the same structural features and the same functions. Where the function and/or structure of such an item have been explained, there is no necessity for repeated explanation thereof in the detailed description.

### List of Reference Numerals:

- 10: a connecting board
- 11: a shoulder
- 12: a second row of solder pads
- 13: traces
- 14: a first row of solder pads
- 15, 15': a second electronic circuit board
- 15a, 15a': a top side of the second circuit board
- 15b: a bottom side of the second circuit board
- 16: a first electronic circuit board
- 16a: a top side of the first circuit board
- 16b: a bottom side of the first circuit board
- 17: an electronic circuit board assembly
- 18, 18a: a row of solder pads of the second circuit board
- 18b: a further row of solder pads
- 19, 19a: a second slit
- 19b: a further second slit
- 20: a row of solder pads of the first circuit board
- 21: a first slit
- 22, 22': a connecting board
- 22a: a back side of the connecting board
- 22b: a front side of the connecting board
- 23: a second slit
- 24: a second row of solder pads
- 25: a first row of solder pads
- 26: traces
- 27: a first slit
- 28, 28': a second circuit board
- 28a: a top side of the second circuit board
- 28b: a bottom side of the second circuit board
- 29, 29': a row of solder pads
- 30: a first circuit board
- 30a: a top side of the first circuit board
- 30b: a bottom side of the first circuit board
- 31, 31': a row of solder pads
- 32: an anchor
- 33a: a first part
- 33b: a further first part
- 34, 35: extending part
- 100: method of manufacturing an electronic circuit board assembly
- 112: providing a first circuit board, a second circuit board, and a connecting circuit board
- 114: electrically connecting the first circuit board to the second circuit board through the connecting circuit board
- 122: electrically connecting the first circuit board to the connecting circuit board
- 124: electrically connecting the second circuit board to the connecting circuit board
- 131: arranging a first slit in at least one of the first circuit board and connecting circuit board
- 132: slotting part of the other one of the first circuit board and connecting circuit board through the first slit
- 133: soldering a row of solder pads of the first circuit board to the first row of solder pads of the connecting circuit board
- 134: arranging a second slit in at least one of the second circuit board and connecting circuit board
- 135: slotting part of the other one of the second circuit board and connecting circuit board through the second slit
- 136: soldering a row of solder pads of the second circuit to the second row of solder pads of the connecting circuit board

### DETAILED DESCRIPTION OF EMBODIMENTS

While this invention is susceptible of embodiment in many different forms, there is shown in the drawings and will herein be described in detail one or more specific embodiments, with the understanding that the present disclosure is to be considered as exemplary of the principles of the invention and not intended to limit the invention to the specific embodiments shown and described.

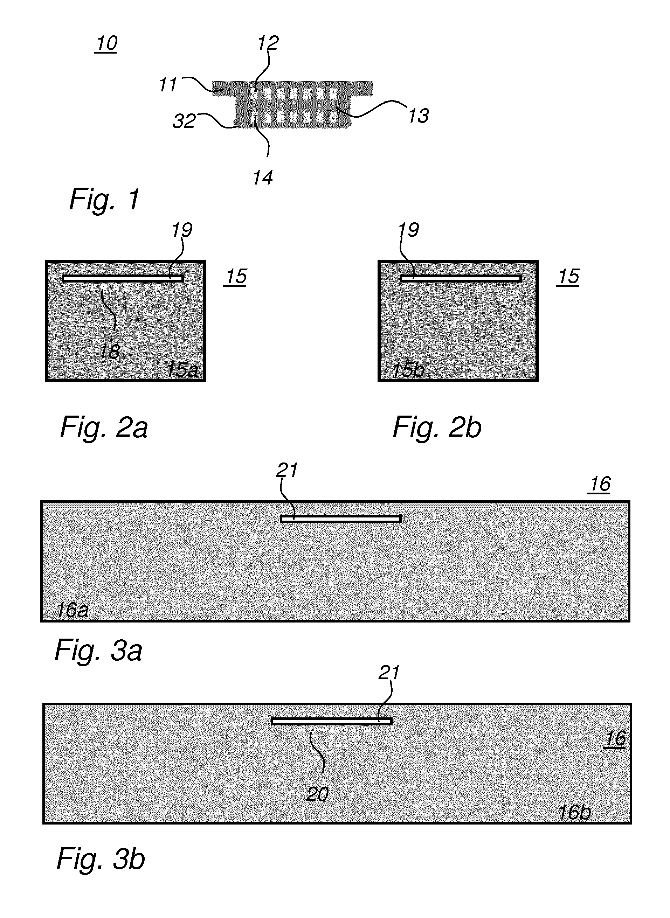

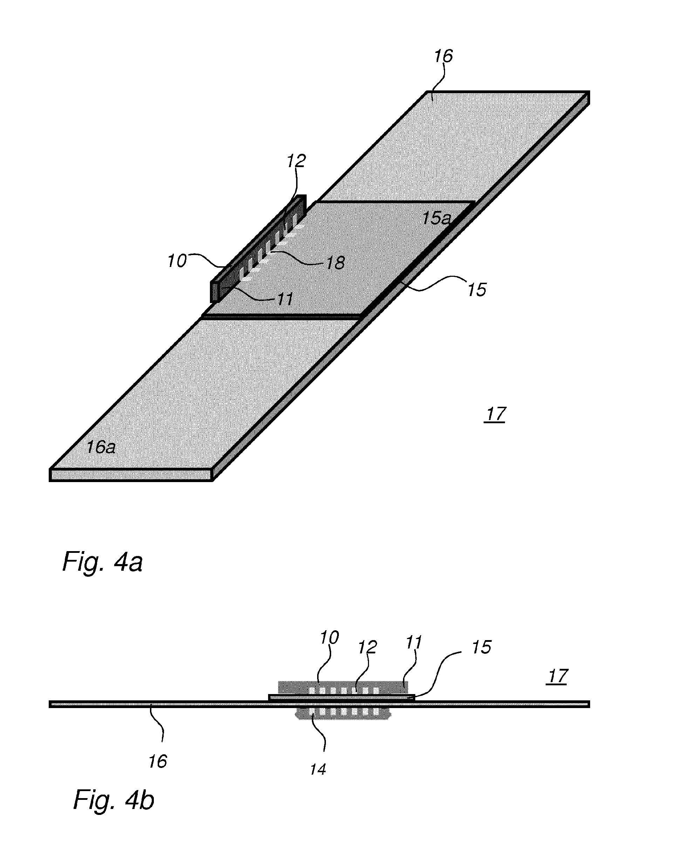

Figs. 1, 2a, 2b, 3a, 3b, 4a, 4b, 4c and 4d relate to electronic circuit board assembly 17. Figs. 4a-4d show electronic circuit board assembly 17 in its assembled form. Figs. 1-3b show individual parts of circuit board assembly 17, used to manufacture assembly 17.

For various reasons it may be desired to distribute electronic components over two circuit boards. For example, there may be size limitation or form factor limitations that force a designer to adopt a design with more than one circuit board. For example, cost consideration may make it desirable to use single sided PCB instead of double sided PCB. Having first and second circuit boards that cooperate electronically, there is a need to provide electronic connections between the two boards.

Circuit board assembly 17 comprises a first circuit board 16, a second circuit board 15, and a connecting circuit board 10. The first circuit board electrically connects first circuit board 16 with second circuit board 15 through a direct soldered connection. For example, a direct soldered connection may be obtained by soldering two adjacent soldering pads together using a soldering material; no intermediate cable or connector is needed.

Connecting circuit board 10 has a front side and a back side. The front side is schematically shown in Fig. 1. The front side of connecting circuit board 10 comprises a second row of solder pads 12, traces 13, and a first row of solder pads 14. Traces 13 connect the first row of solder pads with the second row of solder pads. For example, the number of solder pads in the first row may equal the number of solder pads in the second row, the traces connecting each pad of the first row with exactly one corresponding pad of the second row. The number of solder pads shown in Fig. 1 is 7; in embodiments this number could both be larger or smaller. In an embodiment, the length of a trace 13 may be conveniently chosen to be less or equal to a sum of a thickness of the first circuit board and a thickness of the second circuit board.

The second circuit board 15 has a top side 15a and a bottom side 15b, schematically shown in Figs. 2a and 2b respectively.

Second circuit board 15 comprises a second slit 19. Second circuit board 15 comprises a row of solder pads 18. Solder pads 18 of the second circuit board are adjacent to second slit 19. In this embodiment, a row of solder pads 18 is applied on the top side 15a of second circuit board 15.

First circuit board 16 comprises a first slit 21. First circuit board 16 comprises a row of solder pads 20. Solder pads 20 of the first circuit board are adjacent to first slit 21. In this embodiment, row of solder pads 20 is applied on the bottom side 16b of first circuit board 16.

In general, a slit is a through-hole that extends linearly across a circuit board, allowing part of a further board to be slotted, i.e. inserted, into the slit.

To assemble circuit board assembly 17, second board 15 may be arranged on top of and parallel to first circuit board 16. The bottom side 15b of the second circuit board faces the top side 16a of the first circuit board. First board 16 and the second board 19 are arranged with respect to each other, so that first slit 21 and second slit 19 are aligned.

Connecting board 10 is slotted, i.e. inserted, simultaneously into both first slit 21 and second slit 19, so that row of solder pads 12 is adjacent to row of solder pad 18 and second slit 19; and so that row of solder pads 14 is adjacent to row of solder pads 20 and first slit 21. The first and second boards are perpendicular to the connecting circuit board. In this embodiment, connecting board 10 has a part that is arranged to be slotted through both the first and second slit. Part of connecting board 10 is not slotted through the slits; in the shown embodiment, the two shoulders 11 are part of a bar extending along the top of connecting board 10; the bar is not slotted.

After insertion, row of solder pads 18 of second circuit board 15 is soldered to second row of solder pads 12 of connecting circuit board 10, and row of solder pads 20 of first circuit board 16 is soldered to first row of solder pads 14 of connecting circuit board 10.

In this embodiment, both first board 16 and second board 15 extend away from the same side of connecting board 10; in this case the front side.

In circuit board assembly 17, the first connecting structure is formed by first slit 21 and connecting board 10; the second connecting structure by second slit 21 and connecting board 10.

The first circuit board, the second circuit board and the connecting boards may be so-called printed circuit boards. A printed circuit board (PCB) mechanically supports and electrically connects electronic components using conductive tracks, pads and other features. The conductive tracks, pads and other features may be etched from an electrically conductive sheet, e.g. a copper sheet, which is laminated onto a non-conductive substrate. PCBs can be single sided (one conductive layer), double sided (two conductive layers) or multi-layer. A side of a PCB with an etched conductive layer, e.g. copper layer, is termed a printed side.

The figures do not show electronic components. The circuit board can support any type of electronic components as is used in the art of PCBs, including, e.g. resistors, capacitors, coils, active circuits, integrated circuits and the like. Some of the components may be attached to the row of solder pads used to connect the first and second circuit board together. The components may be attached, using surface mounting, e.g. on a printed side of the PCB. Components may also be attached using through-hole construction, in which component leads are inserted in (non-plated) holes; in assembly 17 this option may be used at places were the first and second circuit boards do not overlap. Different attachment methods may be combined.

In assembly, any one of the circuit boards may be single or double side, or even multi-layer. For example, in a variant of assembly 17, connecting board 10 is a double sided PCB. In that case, the back side of the connecting board may also comprise two rows of solder pad connected through traces. First and second circuit may then comprise two rows of solder pads, at opposite sides of the first and second slit respectively, though at the same side. In this case, twice the number of connections between the first and second circuit board can be made, without making the connecting board larger. In this embodiment the first and second circuit boards may be single side, or double sided or more.

The first and/or second circuit boards may be single-sided printed circuit boards; in particular this may be done in assembly 17. In this embodiment, the connecting board may be single sided or double sided, or more. In particular, first and second circuit boards, and the connecting board may all be single sided. Bottom side 16b of the first circuit and top side 15a of the second circuit board are the printed sides. Components may be surface mounted on the printed side (not shown). The printed sides of the first and second circuit boards are facing away from each other.

In an embodiment, the first and second circuits and the connecting board are singled-sided PCBs. In an embodiment, the first and second circuits are singled-sided PCBs, the connecting board is a double-sided PCB.

The single sided circuit boards may comprise a non-conductive substrate based on cellulose paper, and not on fiber glass. A single sided circuit board may, e.g. be of so-called grade FR1 and/or FR2, e.g. according to the 'Specification for Base Materials for Rigid and Multilayer Printed Boards' Product Code: 4101C

Using single sided circuit boards is particularly cost-efficient. Consider an alternative solution, for comparison that does not use a connecting board 10: The second circuit boards is placed on top of the first circuit board and soldered together at the edges (side-soldering) of the second circuit board onto the first circuit board. As such the second circuit board requires FR4 material (fiber-glass based substrate) as plated through holes are required at the edges of the second circuit board for soldering the second circuit board to the first circuit board.

Using a connecting board, e.g. as shown in assembly 17, does not require the second circuit board to be of FR4 quality.

Below the costs of assembly 17 having a single-sided first and second circuit board is compared to an assembly solution with a same sized first and second circuit board but which uses side-soldering instead of a connecting board:

### Side soldering

| | |
|---|---|
| First circuit board FR1 single sided (42x200 mm): | USD 0.21 |
| Second circuit board FR4 (40x45 mm): | USD 0.22 |

The second circuit FR4 PCB cost more than the first circuit board even though the second circuit board is only -21.4% of the first circuit board area. Using FR1 material for the second circuit board, cost savings are achieved:

### Assembly 17

| | |
|---|---|
| First circuit board FR1 single sided (42x200 mm): | USD 0.21 |
| Second circuit board FR1 (40x45 mm): | USD 0.12 |

Cost of the second circuit board has been reduced by 45% by changing from FR4 to FR1. This is a substantial cost saving. Note that the costs of the connecting board are negligible.

Below a number of additional possibilities are discussed which have been applied in assembly 17 as shown.

Connecting circuit board 10 may comprises at least one shoulder 11. Shoulder 11 is adjacent to the second row of solder pads and extends from connecting circuit board 10. When connecting board 10 is slotted through the first and second slit, shoulder 11 rests on second circuit board 15. The shoulder has been arranged with respect to the second row of solder pads so that, second row of solder pads 12 is aligned with the row of solder pads 18 of the second circuit board when the shoulder rest on the second circuit board. The shoulder makes assembly easier, as a manufacturer can easily align the solder pads. Assembly 17 shows a second shoulder on connecting board 10 at the other side of second row solder pads 12. Nevertheless, the shoulders could be omitted.

Connecting circuit board 10 may comprise an anchor 32. Anchor 32 is arranged to allow insertion of the anchor through the first and second slit together with first row 14, but to resist retraction of the part from the first and second slit. Anchors 32 may be made out of PCB material. Anchors improve the mechanical reliability of the connection between the first and second circuit board.

Assembly 17, especially when using single-sided first and second circuit boards provides a tight mechanical integration, in which non-conducting sides are facing each other.

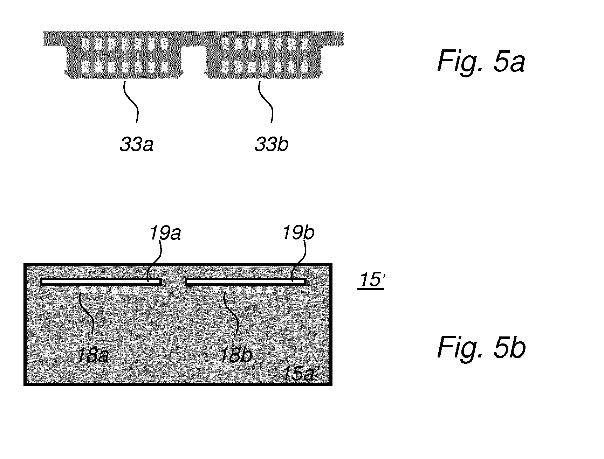

Figs. 5a and 5b relate to an embodiment using further slits in addition to the first and second slit. Fig. 5a is a schematic front view of an embodiment of a connecting circuit board having two parts arranged to slot through a slit. Fig. 5b is a schematic top view of an embodiment of a second circuit board having a second slit and a further second slit.

This embodiment is the same as assembly 17 as described above, except as to the number of slits and the number of parts slotting into the slits.

Fig. 5b shows a second circuit board 15'. The second circuit board comprises a second slit 19a and further comprises a further second slit 19b. The second and further second slits are collinear. Fig. 5a shows a connecting board that has a first part 33a arranged to be slotted into second slit 19a, and a further part 33b for slotting into the further second slit. Using multiple slits allows a designer to avoid a component on the circuit board, e.g. a connector, a coil and the like.

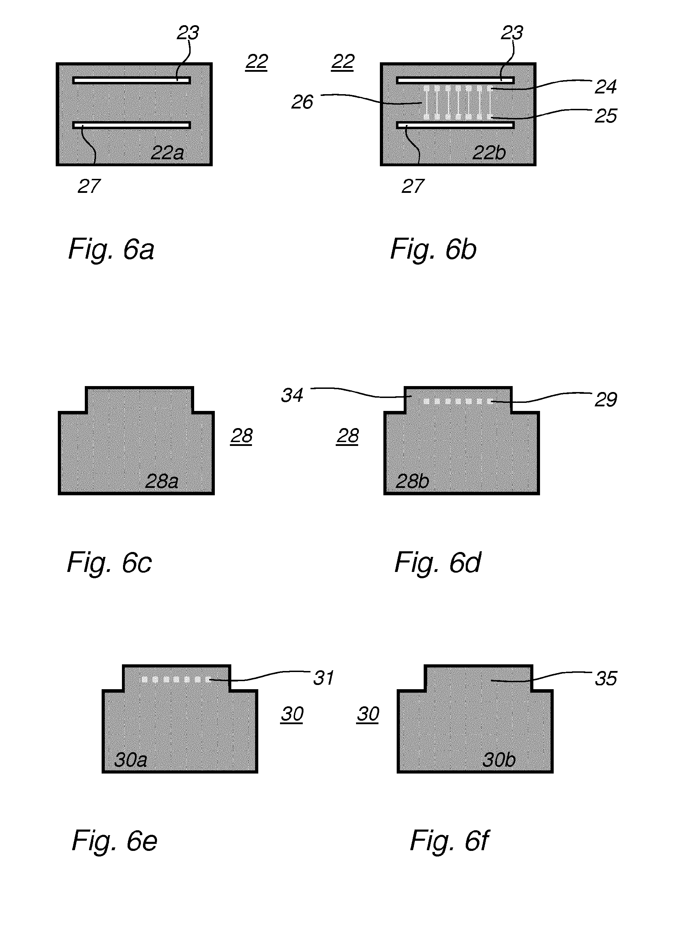

Figs. 5a and 5b do not show the first circuit board. A suitable first circuit board may be obtained by modifying first circuit board 16 in the same way second circuit board 15 was modified to obtain second circuit board 15', i.e. by adding a slit. Like in the embodiments shown with respect to Figs. 6a-6f, a further slits may also be added in the connecting board.

Figs. 6a-6f relate to the same embodiment of an electronic circuit board assembly. This embodiment of an electronic circuit board assembly comprises a first circuit board 30, a second circuit board 28, and a connecting circuit board 22. Connecting circuit board 22 electrically connects first circuit board 30 with second circuit board 28. The embodiments of Figs. 6a-6f differ in the location of the slits.

Fig. 6a is a schematic back view 22a of an embodiment of a connecting circuit board 22. Fig. 6b is a schematic front view 22b of an embodiment of a connecting circuit board 22.

Connecting board 22 comprises a first slit 27 and a second slit 23. In the shown embodiment, first slit 27 is parallel to the second slit 23. In this case a second board 28 will be arranged on top of and parallel to a first circuit board 30. Alternatively, first slit 27 may be arranged in line with, i.e. collinear, with second slit 23. In the latter case, second board 28 will be arranged next to and coplanar with first circuit board 30.

Connecting board 22 has a back side 22a and a front side 22b. Front side 22b comprises a second row of solder pads 24, a first row of solder pads 25 and traces 26 connecting the second row of solder pads 24 to the first row of solder pads 25.

Fig. 6c is a schematic top view of second circuit board 28. Fig. 6d is a schematic bottom view of second circuit board 28.

Second circuit board 28 comprises a top side 28a and a bottom side 28b. Second circuit board 28 comprises a part 34 extending from a component part of second circuit board 28. Extending part 34 is arranged for slotting through second slit 23. Part 34 comprises a row of solder pad 29 arranged for connecting to the second row 24. The solder pads are slotted through the slit.

Fig. 6e is a schematic top view of an embodiment of a first circuit board. Fig. 6f is a schematic bottom view of the embodiment of the first circuit board.

First circuit board 30 comprises a top side 30a and a bottom side 30b. First circuit board 30 comprises a part 35 extending from a component part of first circuit board 30. Extending part 35 is arranged for slotting through the first slit. Part 35 comprises a row of solder pad 31 arranged for connecting to the first row 25.

To assemble this circuit board assembly: second circuit board 28 is inserted at back side 22a into second slit 23. Bottom side 28b is facing towards second row 24; first circuit board 30 is inserted at back side 22a into first slit 27. Top side 30a is facing towards first row 25. The solder pads 31 of the first circuit are soldered to first row 25, the solder pads 29 of the second circuit are soldered to second row 24. The solder pads are connected to electronic components on the first and second circuit sides respectively.

A non-conductive spacer may be applied between the first and second circuit board. The spacer may be used as heat sink. The spacer may be potting material. In electronics, potting is a process of filling a complete electronic assembly with a solid or gelatinous compound, known as potting material. Potting material is also referred to as 'potting glue'. Thermo-setting plastics or silicone rubber gels may be used for this purpose. The potting material conducts heat away from the electronic assembly. Interestingly, the printed sides in the assembly of Figs. 6a-6f face each other. This means that the resulting assembly is less easily damaged, making this form of cooling especially convenient.

In an assembly, in which the connecting board comprises one or more slits a spacer improves the mechanical integrity of the design.

The extending parts 34 and 35 may be provided with anchors. The anchors resist pulling the circuit back from the slit, once it has been inserted. In this case the component sides, i.e. the non-extending parts, of the first and second circuits function as shoulders.

Any one of the first and second circuit board and the connecting board may be a single sided PCB, double sided PCB or multi-layered PCB. For example, first and second circuit board and the connecting board may all be single sided PCB. For example, the first and second circuit board may be single sided PCB, but the connecting board may be double sided.

In Figs. 6a-6f, the first connecting structure is formed by first slit 27 and extending part 35; the second connecting structure by second slit 23 and extending part 34. It is possible to replace any one of the first and second connecting structure with the connecting structures shown for assembly 17, using a slit in the first or second connecting board.

In Fig. 6a, the rows soldering pads are facing each other, being arranged between the slits of the connecting board. This arrangement makes the soldering harder, though not impossible. To ease access to the soldering pads for soldering, one or both of the rows of soldering pads may be arranged at the other side of the corresponding slit. The traces connecting the two slits will then run around the board, instead of being a straight connection. If needed the connecting board may be made somewhat broader to accommodate such a layout of the traces. If the position of a soldering pad is changed with respect to the adjacent slit, the printed side of the circuit board is correspondingly reversed. A similar change in the position of a row of soldering pad with respect to the adjacent slit can be made in the other embodiments.

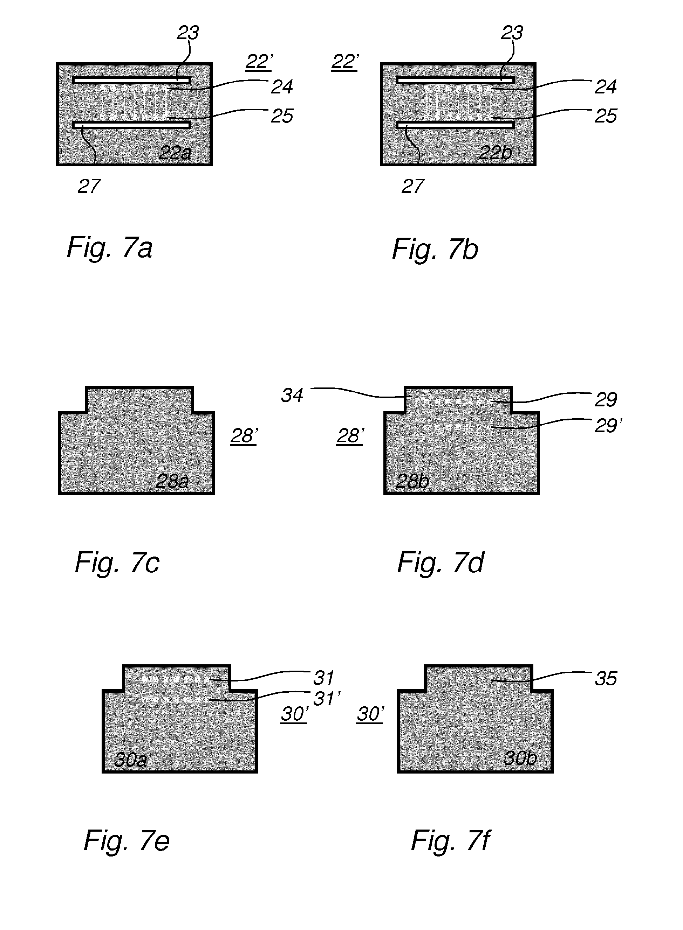

Fig. 7a-7f illustrate an embodiment of the assembly of Figs. 6a-6f with a double sided connecting board, both the front and back side of the connecting board contain solder pads and traces. For example, the connecting board 22' of Fig. 7a and 7b may be the same, front and back, as front side 22b depicted in Fig. 6b. There is no reason that the front and back have the same number of solder pad though.

First circuit board 30' and second circuit board 28' are also the same as the first and second circuit boards shown in Figs. 6c-6f, except that an additional row of solder pads have been added. Second circuit board 28' comprises an additional row of solder pads 29', parallel to row of solder pads 29; First circuit board 30' comprises an additional row of solder pads 31', parallel to row of solder pads 31.

When the first and second circuit boards are inserted into the first and second slit respectively, the additional rows of solder pads 29' and 31' align with solder pads on the opposite side of the connecting board as row of solder pads 29 and 31.

The connecting board is a relatively small circuit board. Accordingly, making the circuit board double sided adds relatively little to the total cost of the circuit board assembly. On the other hand, the number of electronic connections that can be made between the first and second board has doubled. A more sided connection board allows even more complicated connections.

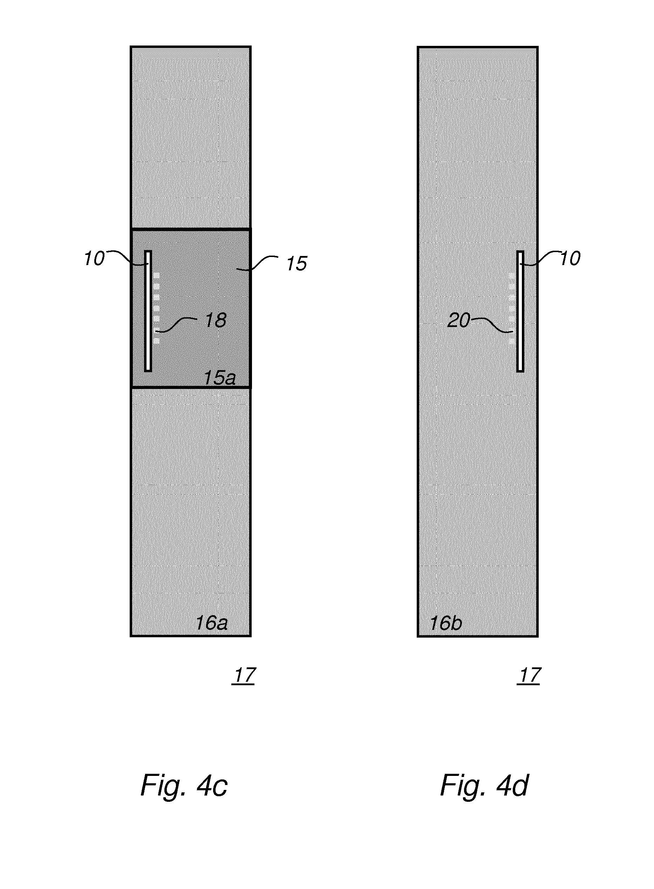

Combinations of the assemblies of Figs. 4 and 6 are possible. For example:

In an embodiment, the first circuit board comprises the first slit, and the connecting circuit board comprises the second slit. In this case a first a part of the second circuit board is slotted through the second slit, and the connecting circuit board is slotted through the first slit.

In an embodiment, the second circuit comprises the second slit, and the connecting circuit board comprises the first slit. A part of the first circuit board is slotted through the first slit, and the connecting circuit board is slotted through the second slit.

In an embodiment of an electronic circuit board assembly, the first row of solder pads, second row of solder pads, the row of solder pads of the first circuit board and the row of solder pads of the second circuit board, all comprise the same number of solder pads, the number being at least 4.

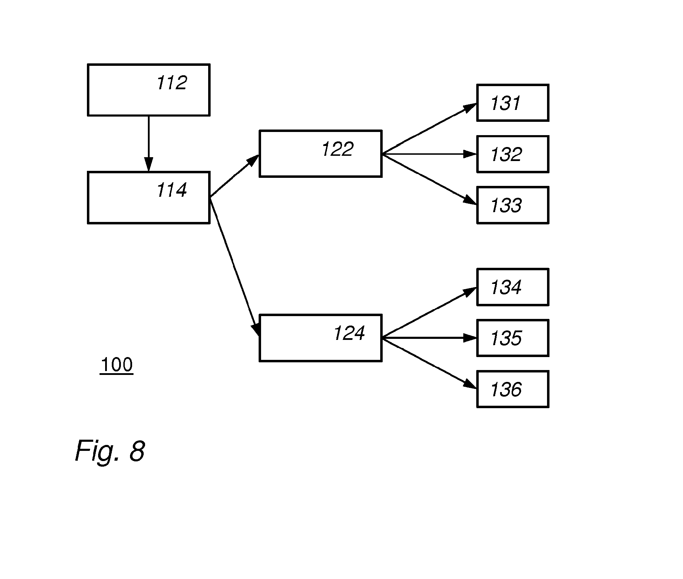

Fig. 8 schematically shows a flowchart of a method 100 for manufacturing an electronic circuit board assembly. Method 100 comprises:

Providing 112 a first circuit board, a second circuit board, and a connecting circuit board, and electrically connecting 114 the first circuit board to the second circuit board through the connecting circuit board.

The connecting 114 of the first circuit board to the second circuit board may be done by electrically connecting 122 the first circuit board to the connecting circuit board, and electrically connecting 124 the second circuit board to the connecting circuit board.

Electrically connecting 122 the first circuit board to the connecting circuit board may be done by arranging 131 a first slit in at least one of the first circuit board and connecting circuit board, slotting 132 part of the other one of the first circuit board and connecting circuit board through the first slit, and soldering 133 a row of solder pads of the first circuit board to the first row of solder pads of the connecting circuit board.

Electrically connecting 124 the second circuit board to the connecting circuit board may be done by arranging 134 a second slit in at least one of the second circuit board and connecting circuit board, slotting 135 part of the other one of the second circuit board and connecting circuit board through the second slit and soldering 136 a row of solder pads of the second circuit to the second row of solder pads of the connecting circuit board.

Figs. 1-3b, 6a-6f, 7a-7f also illustrate a kit for manufacturing an electronic circuit board assembly, i.e. a collection of parts adapted to each other for manufacturing the electronic circuit board assembly.

It should be noted that the above-mentioned embodiments illustrate rather than limit the invention, and that those skilled in the art will be able to design many alternative embodiments.

In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. In the device claim enumerating several means, several of these means may be embodied by one and the same item of hardware. The mere fact that certain measures are recited in mutually different dependent claims does not indicate that a combination of these measures cannot be used to advantage.

## Claims

1. An electronic circuit board assembly (17) comprising
a first circuit board (16, 30),
a second circuit board (15, 28),
a connecting circuit board (10,22) electrically connecting the first circuit board with the second circuit board,
a first connecting structure electrically connecting the first circuit board to the connecting circuit board, at least one of the first circuit board and connecting circuit board comprising a first slit, part of the other one of the first circuit board and connecting circuit board being slotted through the first slit, and
a second connecting structure electrically connecting the second circuit board to the connecting circuit board, at least one of the second circuit board and connecting circuit board comprising a second slit, part of the other one of the second circuit board and connecting circuit board being slotted through the second slit.

2. An electronic circuit board assembly (17) as claimed in Claim 1, wherein the second board is arranged parallel to the first circuit board, and wherein the first and second board are perpendicular to the connecting circuit board

3. An electronic circuit board assembly (17) as claimed in Claim 1, wherein
the first circuit board (16) comprises the first slit, the second circuit board (15) comprises the second slit (19), the connecting circuit board (10) being slotted through the first and second slit,
or
the connecting circuit board (22) comprises the first and second slit, a part of the first circuit board (28) being slotted through the first slit, a part of the second circuit board (28) being slotted through the second slit,
or
the first circuit board comprises the first slit, the connecting circuit board comprises the second slit, a part of the second circuit board (28) being slotted through the second slit, the connecting circuit board (10) being slotted through the first slit,
or
the second circuit comprises the second slit, the connecting circuit board comprises the first slit, a part of the first circuit board (28) being slotted through the first slit, the connecting circuit board (10) being slotted through the second slit.

4. An electronic circuit board assembly (17) as claimed in Claim 1, wherein
the part of the other one of the first circuit board and connecting circuit board that is slotted through the first slit comprises a row of solder pads, and/or
the part of the other one of the second circuit board and connecting circuit board that is slotted through the second slit comprises a row of solder pads.

5. An electronic circuit board assembly (17) as claimed in Claim 1, wherein
the part of the other one of the first circuit board and connecting circuit board that is slotted through the first slit comprises an anchor (32), the anchor being arranged to allow insertion of the anchor through the first slit and to resist retraction of the part from the first slit, and/or
the part of the other one of the first circuit board and connecting circuit board that is slotted through the second slit comprises an anchor (32), the anchor being arranged to allow insertion of the anchor through the second slit and to resist retraction of the part from the second slit.

6. An electronic circuit board assembly as claimed in Claim 1, wherein
the connecting circuit board comprises a first row of solder pads (14, 25), a second row of solder pads (12, 24), and traces (13, 26) connecting the first row of solder pads with the second row of solder pads,
the first circuit board (16, 30) comprises a row of solder pads (20), the row of solder pads of the first circuit board being soldered to the first row of solder pads (14) of the connecting circuit board, the first row of solder pads of the connecting circuit board and the row of solder pads of the first circuit board being adjacent to the first slit
the second circuit board (15, 28) comprises a row of solder pads (18), the row of solder pads of the second circuit board being soldered to the second row of solder pads (12) of the connecting circuit board, the second solder pads of the connecting circuit board and the row of solder pads of the second circuit board being adjacent to the second slit.

7. An electronic circuit board assembly as claimed in Claim 1, wherein the first and second circuit boards are single-sided printed circuit boards.

8. An electronic circuit board assembly as claimed in Claim 1, wherein the connecting circuit board is a single-sided printed circuit board.

9. An electronic circuit board assembly as claimed in Claim 1, wherein the second circuit board comprises the second slit, and the connecting circuit board comprises at least one shoulder (11) adjacent to the second row of solder pads (12) and extending from the connecting circuit board, so that the second row of solder pads is aligned with the row of solder pads of the second circuit board when the shoulder rest on the second circuit board.

10. An electronic circuit board assembly as claimed in Claim 1, wherein, the connecting board is a double-sided printed circuit board, the connecting board comprising on each side: a first row of solder pads, a second row of solder pads, and traces connecting the first row of solder pads with the second row of solder pads, the first circuit board comprising two rows of solder pads, the two rows of solder pads of the first circuit board being soldered to a first row of solder pads on each side of the connecting circuit board, the second circuit board comprises two rows of solder pads, the two rows of solder pads of the second circuit board being soldered to the second row of solder pads on each side of the connecting circuit board.

11. An electronic circuit board assembly as claimed in Claim 1, wherein
the at least one of the first circuit board and connecting circuit board comprising the first slit (19a) further comprises a further first slit (19b), the first and further first slit being collinear, the other one of the first circuit board and connecting circuit board having a first part (33a) being slotted through the first slit (19a), and a further first part (33b) being slotted through the further first slit (19b), and/or
the at least one of second circuit board and connecting circuit board comprising the second slit (19a) further comprises a further second slit (19b), the second and further second slit being collinear, the other one of the second circuit board and connecting circuit board having a second part (33a) being slotted through the second slit (19a), and a further second part (33b) being slotted through the further second slit (19b).

12. An electronic circuit board for use in an electronic circuit board assembly as claimed in Claim 1, comprising
a slit for receiving a connecting circuit board and a row of solder pads adjacent to the slit, or
a part of the circuit board arranged for slotting through a slit, the part of the circuit board comprising a row of solder pads.

13. A method for manufacturing an electronic circuit board assembly (17), the method comprising:
providing a first circuit board (16, 30), a second circuit board (15, 28), and a connecting circuit board (10,22),
electrically connecting the first circuit board to the second circuit board through the connecting circuit board, comprising
electrically connecting the first circuit board to the connecting circuit board, comprising arranging a first slit in at least one of the first circuit board and connecting circuit board, and slotting part of the other one of the first circuit board and connecting circuit board through the first slit, and
electrically connecting the second circuit board to the connecting circuit board, comprising arranging a second slit in at least one of the second circuit board and connecting circuit board, and slotting part of the other one of the second circuit board and connecting circuit board through the second slit.

14. A method for manufacturing an electronic circuit board assembly as claimed in Claim 13, wherein the connecting circuit board comprises a first row of solder pads, a second row of solder pads, and traces connecting the first row of solder pads with the second row of solder pads, the method comprising
soldering a row of solder pads of the first circuit board to the first row of solder pads of the connecting circuit board, and
soldering a row of solder pads of the second circuit to the second row of solder pads of the connecting circuit board.

15. A kit for manufacturing an electronic circuit board assembly, the kit comprising:
a first circuit board (16, 30), a second circuit board (15, 28), and a connecting circuit board (10,22) arranged for electrically connecting the first circuit board with the second circuit board,
at least one of the first circuit board and connecting circuit board comprising a first slit, part of the other one of the first circuit board and connecting circuit board being arranged for slotted through the first slit, and
at least one of the second circuit board and connecting circuit board comprising a second slit, part of the other one of the second circuit board and connecting circuit board being arranged for slotting through the second slit.
